# EUROPÄISCHE PATENTSCHRIFT

(11) **EP 1 895 189 B1**
(45) Veröffentlichungstag und Bekanntmachung des Hinweises auf die Patenterteilung: **04.03.2009**
(21) Anmeldenummer: 06018174.0
(22) Anmeldetag: 31.08.2006
(51) Int. Cl.: F16F 15/027, F16F 15/023, G03F 7/20

(54) **Aktives Schwingungsisolationssystem mittels hysteresefreier pneumatischer Lagerung**
Active vibration isolation system having a hysteresis free pneumatic bearing
Système actif d'amortissement de vibrations avec un support pneumatique sans hystérésis

(43) Veröffentlichungstag der Anmeldung: 05.03.2008
(73) Patentinhaber: Integrated Dynamics Engineering GmbH, 65479 Raunheim (DE)
(72) Erfinder: Heiland, Peter, 65479 Raunheim (DE)
(74) Vertreter: Blumbach - Zinngrebe

(56) Entgegenhaltungen:
- EP-A2- 0 814 279
- JP-A- 8 075 033
- US-A- 5 285 995
- US-A1- 2002 120 415

## Beschreibung

### Gebiet der Erfindung

Die Erfindung bezieht sich auf eine Anordnung zur Schwingungsisolation einer Masse nach dem Oberbegriff des Anspruchs 1 und auf ein Verfahren zur Schwingungsisolation der Masse.

### Hintergrund der Erfindung

Derartige Schwingungsisolationssysteme mit pneumatischen Isolatoren sind aus dem Stand der Technik, z.B. aus der EP 0 814 279 A, bekannt. Die EP0927380B1=US6226075B1 beschreibt ein horizontal und vertikal wirksames Luftlager, mit dem beispielsweise ein lithographisches System als Masse gestützt wird. Zur Unterdrückung auftretender Schwingungen werden zudem elektrisch ansteuerbare Aktoren verwendet, die die Masse parallel zu den pneumatischen Isolatoren stützen.

Pneumatische Lagerungen, auch Isolatoren genannt, eignen sich zur Konstruktion eines Schwingungsisolationssystem insbesondere deshalb, weil sie es ermöglichen, die Steifigkeit der Lagerung sehr klein zu halten. Dies bedingt jedoch einen ständig fließenden Leckstrom aus dem Luftlager heraus, der ergänzt werden muss. Solche Luftlager haben auch den Vorteil, die gesamte schwingungsisolierte Masse in der Höhe verfahren zu können und so einen oder mehrere Arbeitspunkte anfahren zu können. Um dies zu ermöglichen, umfassen die Isolatoren elektrisch ansteuerbare Ventile, die mittels eines elektrischen Steuersignals den Druckluftstrom von einer Druckluftversorgung in die Isolatoren regeln, und auf diese Weise den Luftdruck in den Isolatoren zu erhöhen oder zu verringern oder auf dem gewünschten Niveau zu halten.

Die Ventile nach dem Stand der Technik zeigen bei der Steuerung des Druckluftstroms eine Hysterese. Dies bedeutet, dass bei gleichem elektrischem Ansteuersignal nicht immer im pneumatischen Isolator der gleiche Druck erzeugt wird. Der erzeugte Druck hängt vielmehr davon ab, welches Ansteuersignal vorher am Ventil angelegen hat. Der Grund für dieses Verhalten der Ventile liegt darin, dass die Ventile zur Steuerung des Druckluftstroms mechanische Elemente enthalten, die der mechanischen Reibung unterliegen. Der Hystereeffekt bedeutet Nicht-Linearität und ist durch einfache Regelungen nicht erfassbar. Beim Ausregeln des Schwingungsisolationssystems treten somit unerwünschte Effekte auf, da das bewegliche mechanische Element des betreffenden Ventils immer wieder aus verschiedenen Ausgangszuständen, insbesondere aus ruhendem Zustand, heraus bewegt werden muss.

### Zusammenfassung der Erfindung

Der Erfindung liegt die Aufgabe zugrunde, Schwingungsisolationssysteme, die über pneumatische Ventile versorgt werden, hysteresearm zu machen.

Hierzu werden die mechanischen Elemente der Ventile immer in Bewegung gehalten, so dass nicht die Notwendigkeit auftritt, diese beweglichen mechanischen Elemente aus der Ruhelage heraus beschleunigen zu müssen.

Dies geschieht dadurch, dass auf das Regel-Ansteuersignal für die Ventile ein zusätzliches Signal, das sog. Dithersignal, addiert wird. Dieses "Anti-Hysterese-Signal" ist in der Amplitude möglichst klein, aber dennoch so groß, dass die beweglichen mechanischen Teile der Ventile im Betrieb des Schwingungsisolationssystems in Bewegung gehalten werden.

Das Dithersignal erzeugt jedoch zusätzliche, unerwünschte Schwankungen des zugeführten Druckluftstroms und damit Druckschwankungen im pneumatischen Isolator. Diese Druckschwankungen im Isolator verursachen eine zusätzliche Bewegung der zu isolierenden Masse vorwiegend in vertikaler Richtung mit der Frequenz des Dithersignals. An der Masse ist also eine Vibrationsstörung mit der Ditherfrequenz feststellbar.

Schaltet man nun ein Dither-Kompensationssignal, zusätzlich zu den Regelsignalen zur Auf- und Abbewegung der schwingungsisolierten Masse, als Kompensationssignal auf die Aktoren des Schwingungsisolationssystems auf, so werden die Vibrationstörungen infolge des Dithersignals auf die zu isolierende Masse mittels der Aktoren kompensiert.

Grundsätzlich ist es auch möglich, die Regelung in nichtadaptiver Form vorzunehmen. D.h. auf das Regelsignal für die Aktoren wird ein konstantes Signal zum Ausgleich des Dithersignals addiert. Eine adaptive Kompensation des Dithersignals hat sich aber als vorteilhaft erwiesen, da die Phasendifferenz zwischen dem Dithersignal auf die Ventile und den messbaren Auswirkungen auf die zu stützende Masse je nach System und über die Zeit auch unter Umständen variabel ist.

In Abhängigkeit vom Schwingungsverhalten der zu stützenden Masse reagiert diese auf das Dithersignal. Liegt beispielsweise die Ditherfrequenz in der Nähe der Eigenfrequenz der zu isolierenden Masse, macht sich die Einspeisung des Dithersignals in starken Schwingungen der Masse bemerkbar. Daher sollte die Frequenz des Dithersignals aus einem Frequenzbereich gewählt werden, in dem die isolierende Masse, z.B. ein schwingungsisoliert zu lagerndes Gerät, besonders unempfindlich ist. Der durch das Dithersignal erzeugt Effekt bleibt dann zwar messbar, aber die sichtbaren Auswirkungen werden minimiert.

### Kurze Beschreibung der Zeichnungen

Ein Ausführungsbeispiel der Erfindung wird anhand der Zeichnung beschrieben.

### Dabei zeigt:

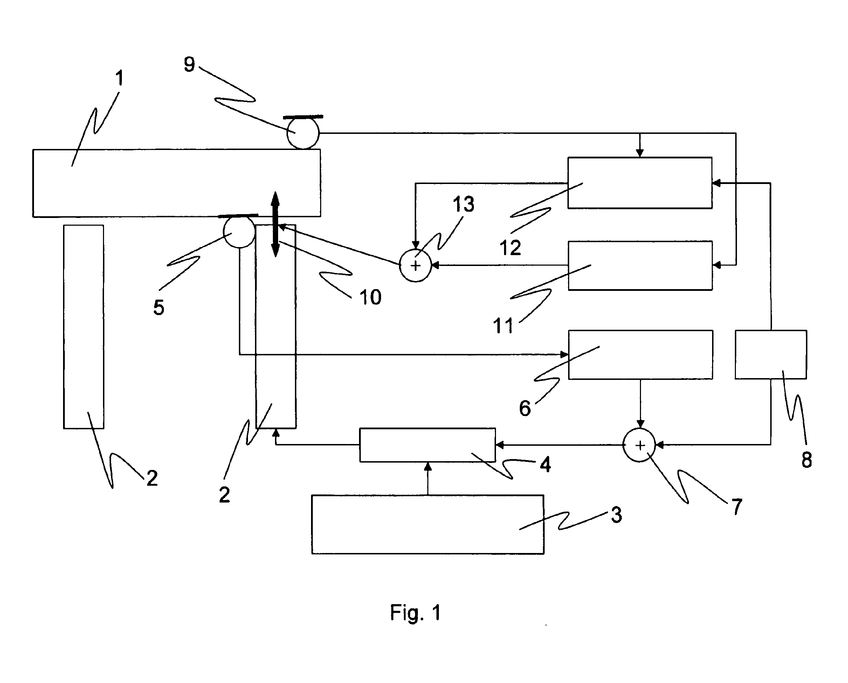

Fig.1 einen schematischen Aufbau des Schwingungsisolationssystems mit einem Regelungssystem.

### Detaillierte Beschreibung

Eine Masse 1 ist auf mehreren pneumatischen Isolatoren 2 oder Luftlagern gelagert, von denen zwei zur senkrechten Abstützung der Masse 1 schematisch dargestellt sind. Solche Isolatoren 2 sind mit einer Druckluftversorgung verbunden, die gewöhnlich ein Druckluftreservoir 3 aufweist, das über Kompressoren gefüllt wird und das über eine oder mehrere Druckluftleitungen den pneumatischen Isolatoren 2 Druckluft zuführt. In jeder dieser Druckluftleitungen ist ein Steuerventil 4 einbezogen, um den Druckluftstrom zu dem jeweiligen Isolator 2 und den Luftdruck in dem Isolator regeln zu können. Der Druckluftstrom kann auch dazu dienen, die Stützlänge der pneumatischen Isolatoren 2 zu verändern bzw. einzustellen. Zur Feststellung des Höhenniveaus der Masse 1 ist ein Positionssensor 5 vorgesehen, der den Abstand der Masse 1 zu einer Bezugsebene zu messen ermöglicht. Der Positionssensor 5 ist mit einem Pneumatik-Regelkreis 6 verbunden, der wiederum über ein Summierglied 7 mit dem Steuerventil 4 in Verbindung steht. Diese Verbindungen sind gewöhnlich elektrischer Natur, d. h. der Positionssensor 5 gibt ein elektrisches Positionssignal an den Pneumatik-Regelkreis 6 ab, der - zusammen mit noch zu beschreibenden Einrichtungen - das Steuerventil 4 so steuert, dass der gewünschte Luftdruck in dem Isolator bzw. das gewünschte Abstützniveau an der Masse 1 erreicht wird.

Bei der Masse 1 handelt es sich gewöhnlich um ein schwingungsempfindliches Gerät, beispielsweise ein Lithographiegerät. Die pneumatischen Isolatoren 2 dienen dazu, ein solches Gerät gegenüber Schwingungen des Untergrunds abzuschirmen. Soweit trotzdem noch Schwingungen in das Gerät gelangen (oder von diesem erzeugt werden), gibt es ein aktives Schwingungsunterdrückungssystem, welches eine Reihe von Aktuatoren 10 enthält, die zwischen einem jeweiligen Isolator 2 und Masse 1 angeordnet sind. Auftretende Schwingungen an der Masse 1 werden über Bewegungssensoren 9 erfasst und einem Schwingungsunterdrückungsregelkreis 11 zugeführt. Der Bewegungssensor 9 kann als Abstands-, Geschwindigkeits- oder als Beschleunigungssensor ausgebildet sein. Der Regelkreis 11 ist über ein weiteres Summierglied 13 mit einem jeweiligen Aktuator 10 verbunden, um beispielsweise im Gegentakt zu den auftretenden Schwingungen auf die Masse 1 einzuwirken.

Um die Masse 1 gegenüber Schwingungen des Untergrundes möglichst gut zu isolieren, werden als Isolatoren 2 Luftlager mit möglichst geringer Federsteifigkeit in horizontaler und vertikaler Richtung verwendet. Solche Luftlager weisen unter anderem einen pneumatischen Kolben auf, der in einem Zylinder geführt wird, wobei ein Druckluft-Leckstrom zwischen Zylinder und Kolben entweicht. Aus diesem Grund muss zur Ergänzung des Druckverlustes dem Isolator 2 ständig Druckluft zugeführt werden, was über das Steuerventil 4 geschieht. Ein solches Steuerventil 4 weist ein bewegliches, mechanisches Ventilglied auf, das mit stationären Ventilwänden zusammenarbeitet, um eine Durchlassöffnung für die Druckluft regelnd zu verändern. Das bewegliche Ventilglied wird durch die elektromotorische Kraft des Steuerventils 4 verstellt, wobei das Ansteuersignal von dem Regelkreis 6 geliefert wird. Das bewegliche Ventilelement unterliegt jedoch der mechanischen Reibung. In der Praxis kann die gewünschte Endstellung des beweglichen Ventilgliedes nicht in einem Zug durch das angelegte Ansteuersignal erreicht werden. Es ergibt sich eine sogenannte Hysterese bei der Steuerung des Druckluftstroms. Die Größe der Hysterese hängt unter anderem auch davon ab, welches vorherige Ansteuersignal am Steuerventil 4 angelegen hat. Hysterese ist ein nichtlinearer Effekt, der durch einfache Regelungen nicht erfassbar ist und deshalb nicht einfach beseitigt werden kann.

Reibung tritt bekanntlich als Haftreibung und Gleitreibung auf, wobei letztere wesentlich geringer ist als erstere. Ein Grundgedanke der Erfindung besteht darin, die Haftreibung bei dem beweglichen Ventilglied auszuschalten. Das bewegliche Ventilglied des Steuerventils 4 wird deshalb in ständiger Bewegung gehalten. Zu diesem Zweck ist ein Dither-Signalgeber 8 vorgesehen, der mit dem Summierglied 7 verbunden ist, um dem beweglichen Ventilglied ein DitherSignal zuzuführen, das für eine ständige Zitterbewegung des beweglichen Ventilglieds sorgt. Auf diese Weise wird vermieden, dass elektrische Ansteuersignale des Pneumatik-Regelkreises 6 die Haftreibung des beweglichen Ventilgliedes zu überwinden haben. Letztendlich wird eine Verringerung der Hysterese des Regelvorganges erreicht.

Als Dithersignal wird vorzugsweise ein Sinussignal mit einstellbarer, aber dann fixer Frequenz verwendet. Die Frequenz des Dithersignals ist deutlich höher, als die Frequenzbandbreite des normalen Regelsignals. Die Frequenzbandbreite für eine pneumatische Steuerung liegt im Bereich 0 bis maximal 20 Hz, während die Frequenz des Dithersignals im Bereich 35 bis 100 Hz liegt.

Die Dither-Bewegung des beweglichen Ventilgliedes führt jedoch auch zu Druckschwankungen in dem pneumatischen Isolator 2 und damit zu einer Schwingungsbeeinflussung der Masse 1. Diese Beeinflussung kann über den Bewegungssensor 9 festgestellt werden. Die Erfindung hat auch damit zu tun, die an der Masse 1 auftretenden Dither-Schwingungen zu unterdrücken. Es ist eine Dither-Kompensationsschaltung 12 vorgesehen, die eingangsseitig mit dem Bewegungssensor 9 und der Dither-Signalgeber 8 und ausgangsseitig mit dem Summierglied 13 verbunden ist. Die Dither-Kompensationsschaltung 12 vergleicht die an der Masse 1 auftretenden Schwingungen mit dem Signal der Dither-Schaltung 8 und gewinnt daraus ein Dither-Beseitigungssignal, das den Aktormitteln 10 zugeführt wird. Auf diese Weise wird den Dither-Schwingungen infolge der Dither-Druckschwankungen im Isolator 2 entgegengewirkt, und es werden die Auswirkungen dieser Schwingungen an der Masse 1 im Wesentlichen beseitigt.

Die Betriebsweise des Schwingungsisolationssystems wird nachfolgend beschrieben. Es sei angenommen, dass die zu isolierende Masse 1 vertikal auf ein bestimmtes Niveau hin bewegt werden soll, z.B. um einen oder mehrere Arbeitspunkte zu erreichen. Hierzu misst der Positionssensor 5 den Abstand zwischen der zu isolierenden Masse 1 und dem zugehörigen Isolator 2. Das Messergebnis wird an den Pneumatik-Regelkreis 6 weitergegeben, der zur Änderung der vertikalen Position der Masse 1 über das erste Summierglied 7 Ansteuersignale an das Steuerventil 4 sendet. In Abhängigkeit von den Ansteuersignalen wird die Öffnungsweite des Steuerventils 4 geändert, so dass aus dem Druckluftreservoir 3 mehr oder weniger Druckluft in den Isolator 2 strömt. Wird aufgrund zuströmender Druckluft der Druck in den Isolatoren 2 erhöht, so wird die zu lagernde Masse 1 nach oben bewegt. Im Falle einer Erniedrigung des Drucks in den Isolatoren 2 wird die zu isolierende Masse 1 nach unten bewegt.

Die Schwingungsisolation der Masse 1 erfolgt dergestalt, dass der Bewegungssensor 9 fortlaufend den Schwingungszustand der zu isolierenden Masse 1 misst. Die Messergebnisse des Bewegungssensors 9 werden an den Schwingungsunterdrückungsregelkreis 11 übertragen. In Abhängigkeit von den erhaltenen Messergebnissen sendet der Regelkreis 11 Signale an die Aktoren 10, die die Masse 1 so bewegen, dass im Ergebnis die sich auf die Masse 1 übertragenden Schwingungen kompensiert werden, so dass im Ergebnis die Masse 1 relativ zum Untergrund ruht oder gleichmäßig zu dieser mit bewegt wird.

Auf das erste Summierglied 7 wird kontinuierlich von dem Dither-Signalgeber 8 das Dithersignal auf das Steuerventil 4 gegeben, so dass die Summe aus dem "normalen" Signal des Pneumatik-Regelkreises 6 und dem Dithersignal des Signalgebers 8 am Steuerventil 4 eintrifft.

Die hierdurch verursachten Dithervibrationen des Ventilgliedes des Steuerventils 4 und damit der Isolatoren 2 übertragen sich auf die zu isolierende Masse 1. Diese Vibrationen der Masse 1 werden vom Bewegungssensor 9 gemessen. Das Messergebnis des Bewegungssensors 9 wird an den Schwingungsunterdrückungsregelkreis 11 weitergeleitet. Die Ditherompensationsschaltung 12 erhält ferner vom Dithersignalgeber 8 das Dithersignal (Nichtadaptives Verfahren der Ditherkompensation).

Der Schwingungsunterdrückungsregelkreis 11 und die Dither-Kompensationssschaltung 12 geben jeweils Signale an das zweite Summierglied 13, das die Summe der beiden Signale an die Aktoren 10 weitergibt. Diese Aktoren 10 stellen Motoren dar, die den wechselnden Abstand zwischen der Masse 1 und den Isolatoren 2 infolge Vibration, hauptsächlich in vertikaler Richtung, derart verändern, dass die vom Dithersignal verursachten Vibrationen der Masse 1 kompensiert werden.

Es ist auch möglich das Messergebnis des Bewegungssensors 9 zusätzlich an die Dither-Kompensationsschaltung 12 weiterzuleiten. In diesem Fall berechnet die Dither-Kompensationsschaltung 12 auf Basis des Dithersignals und der Messergebnisse des Bewegungssensors 9 ein Dither-Kompensationssignal, das an das zweite Summierglied 13 weitergegeben wird. Der Unterschied zum bereits beschriebenen nichtadaptiven Verfahren besteht darin, dass das Ditherkorrektursignal vom jeweiligen Schwingungszustand der Masse 1 abhängt, und daher die auftretenden Dithervibrationen besser kompensiert werden können (Adaptives Verfahren der Ditherkompensation).

Wird die Masse 1 in der bereits beschriebenen Weise in der Höhe verfahren, z.B. um einen oder mehrere Arbeitspunkte zu erreichen, so wird mittels der Messergebnisse des Positionssensors 5 die Differenz zwischen Soll- und Isthöhe der Masse 1 bestimmt. Nähert sich die Masse 1 der vorgegebenen Sollhöhe, so geht diese Differenz gegen Null. In der Praxis gibt es bei Regelvorgängen eine sogenannte Regelschwankung um den Sollwert, hier die Sollhöhe. Da das zusätzlich eingespeiste Dithersignal eine Amplitude aufweist, die gerade noch ausreicht, um das bewegliche Ventilglied in Bewegung zu halten, schwingt das Luftlager 2 mit einer kleinen Amplitude um den Sollwert, d.h. es wird eine Regelschwankung erzeugt, deren Muster aber genau bekannt ist. Deshalb ist es möglich, diese Regelschwankung am Zielobjekt, der Masse 1, weitgehend auszuschalten. Insgesamt wird so eine bessere, genauere Positionierung der Masse 1 erreicht, als dies ohne Aufschaltung des Dither-Kompensationssignals möglich ist.

## Patentansprüche

1. Anordnung zur Schwingungsisolation einer Masse (1), umfassend:
Luftlagermittel (2) zur Abstützung der Masse (1);
eine Einrichtung zur Druckversorgung der Luftlagermittel (2), die eine Druckluftquelle (3) und ein Steuerventil (4) für einen dem Luftlagermittel (2) zuzuführenden Druckluftstrom aufweist;
ein Pneumatik-Regelkreis (6) zur Steuerung des Steuerventils (4), das ein bewegliches Ventilglied aufweist;
Aktormittel (10) zur schwingungsunterdrückenden Abstützung der Masse (1);
Sensormittel (9) zur Feststellung des Schwingungszustands der Masse (1);
ein Schwingungsunterdrückungsregelkreis (11) zur Steuerung der Aktormittel (10) in Abhängigkeit der Sensormittel (9);
**dadurch gekennzeichnet,**
**dass** ein Dither-Signalgeber (8) zur Beeinflussung des Bewegungszustands des Ventilgliedes vorgesehen ist, wobei Dither-Vibrationen der Masse (1) erzeugt werden, und
**dass** eine Dither-Kompensationsschaltung (12) vorgesehen ist, um die Aktormittel (10) im Sinne der Unterdrückung der Dither-Vibration der Masse (1) zu steuern.

2. Anordnung zur Schwingungsisolation gemäß Anspruch 1, **dadurch gekennzeichnet, dass** der Pneumatik-Regelkreis (6) mit Regelschwankungen um jeweils einen vorgegebenen Sollwert betreibbar ist, wobei die Regelschwankungen durch das Dithersignal extern vorgegeben werden.

3. Anordnung zur Schwingungsisolation gemäß Anspruch 1 oder 2, **dadurch gekennzeichnet, dass** der Pneumatik-Regelkreis (6) ein erstes Summierglied (7) umfasst, über das der Dither-Signalgeber (8) an das Steuerventil (4) angeschlossen ist.

4. Anordnung zur Schwingungsisolation gemäß Anspruch 1, 2 oder 3, **dadurch gekennzeichnet, dass** der Pneumatik-Regelkreis (6) einen Positionssensor (5) umfasst.

5. Anordnung zur Schwingungsisolation nach einem der Ansprüche 1 - 4, **dadurch gekennzeichnet, dass** der Schwingungsunterdrückungsregelkreis (11) ein zweites Summierglied (13) umfasst, über das die Dither-Kompensationsschaltung (12) an den Aktormitteln (10) angeschlossen ist.

6. Anordnung zur Schwingungsisolation nach einem der Ansprüche 1 - 5, **dadurch gekennzeichnet, dass** der Dither-Signalgeber (8) ausgangsseitig mit einem Eingang der Dither-Kompensationsschaltung (12) verbunden ist.

7. Anordnung zur Schwingungsisolation nach einem der Ansprüche 1 - 6, **dadurch gekennzeichnet, dass** die Dither-Kompensationsschaltung (12) mit den Sensormitteln (9) zur Feststellung des Schwingungszustands der Masse (1) verbunden ist und **dadurch** in einen Regelkreis eingebunden ist.

8. Anordnung zur Schwingungsisolation nach einem der Ansprüche 1 - 7, **dadurch gekennzeichnet, dass** der Dither-Signalgeber (8) ein Sinussignalgeber ist.

9. Anordnung zur Schwingungsisolationn gemäß Anspruch 8, **dadurch gekennzeichnet, dass** die Frequenz des Dithersignals zwischen 35 und 100 Hz liegt.

10. Verfahren zur Schwingungsisolation einer Masse (1) durch Abstützung über eine Luftlagerung (2), mit folgenden Schritten:
a)Regelung des Luftdrucks in der Luftlagerung (2) durch Zufuhr von Luft über Steuerventile (4), die jeweils ein bewegliches Ventilglied aufweisen und Abfuhr von Luft aus der Luftlagerung (2);
b)Erzeugen eines Regelsignals für einen Pneumatik-Regelkreis (6) zur Beeinflussung der Stellung des Beweglichen Ventilglieds des Steuerventils (4);
c)Überlagerung des Regelsignals mit einem Dithersignal, das zu einer Dithervibration des beweglichen Ventilglieds führt;
d)Feststellen ausgelöster Dithervibrationen als Auswirkung auf den Schwingungszustand der Masse (1), und
e)Kompensation der Dithervibrationen durch kompensierende Steuerung von Aktoren (10), die auf die Masse (1) wirken.

11. Verfahren zur Schwingungsisolation gemäß Anspruch 10, **dadurch gekennzeichnet, dass** der Pneumatik-Regelkreis (6) mit Regelschwankungen um jeweils einen vorgegebenen Sollwert betrieben wird und die Regelschwankungen durch das Dithersignal extern bestimmt werden.

12. Verfahren zur Schwingungsisolation gemäß Anspruch 10 oder 11, **dadurch gekennzeichnet, dass** der Schritt e) unter Mithilfe eines Schwingungsunterdrückungsregelkreises (11) und einer Dither-Kompensationsschaltung (12) ausgeführt wird, wobei der Dither-Kompensationsschaltung (12) Dithersignale zugeführt werden.

13. Verfahren zur Schwingungsisolation gemäß Anspruch 12, **dadurch gekennzeichnet, dass** der Dither-Kompensationsschaltung (12) Signale gemäß Schritt d) zugeführt werden.

14. Verfahren zur Schwingungsisolation nach einem der Ansprüche 10 - 13, **dadurch gekennzeichnet, dass** das Dithersignal ein Sinussignal ist.

15. Verfahren zur Schwingungsisolation gemäß Anspruch 14, **dadurch gekennzeichnet, dass** die Frequenz des Dithersignals zwischen 35 und 100 Hz liegt.

## Claims

1. Arrangement for vibration isolation of a mass (1) comprising:
air bearing means (2) for supporting the mass (1);
a device for supplying pressure to the air bearing means (2) which comprises a compressed-air source (3) and a control valve (4) for a compressed-air flow to be supplied to the air bearing means (2);
a pneumatic control loop (6) for controlling the control valve (4) which comprises a mobile valve element;
actuator means (10) for vibration-suppressing support of the mass (1);
sensor means (9) for determining the vibration state of the mass (1);
a vibration suppression control loop (11) for controlling the actuator means (10) as a function of the sensor means (9);
**characterised in that**
a dither signal transmitter (8) is provided in order to influence the movement state of the valve element, wherein dither vibrations of the mass (1) are produced, and
**in that** a dither compensation circuit (12) is provided in order to control the actuator means (10) in terms of suppressing the dither vibration of the mass (1).

2. Arrangement for vibration isolation as claimed in Claim 1, **characterised in that** the pneumatic control loop (6) can be operated with control fluctuations about a respective predetermined nominal value, wherein the control fluctuations are predetermined externally by the dither signal.

3. Arrangement for vibration isolation as claimed in Claim 1 or 2, **characterised in that** the pneumatic control loop (6) has a first addition element (7) via which the dither signal transmitter (8) is connected to the control valve (4).

4. Arrangement for vibration isolation as claimed in Claim 1, 2 or 3, **characterised in that** the pneumatic control loop (6) has a position sensor (5).

5. Arrangement for vibration isolation as claimed in any one of Claims 1 to 4, **characterised in that** the vibration suppression control loop (11) has a second addition element (13) via which the dither compensation circuit (12) is connected to the actuator means (10).

6. Arrangement for vibration isolation as claimed in any one of Claims 1 to 5, **characterised in that** the output side of the dither signal transmitter (8) is connected to an input of the dither compensation circuit (12).

7. Arrangement for vibration isolation as claimed in any one of Claims 1 to 6, **characterised in that** the dither compensation circuit (12) is connected to the sensor means (9) for determining the vibration state of the mass (1), and is thereby included in a control loop.

8. Arrangement for vibration isolation as claimed in any one of Claims 1 to 7, **characterised in that** the dither signal transmitter (8) is a sinusoidal signal transmitter.

9. Arrangement for vibration isolation as claimed in Claim 8, **characterised in that** the frequency of the dither signal is between 35 and 100 Hz.

10. Method for vibration isolation of a mass (1) by supporting it via an air bearing (2), having the following steps:
a) controlling the air pressure in the air bearing (2) by supplying air via control valves (4), which each comprise a mobile valve element, and by removing air from the air bearing (2);
b) producing a control signal for a pneumatic control loop (6) in order to influence the position of the mobile valve element of the control valve (4);
c) superimposing a dither signal on the control signal, resulting in dither vibration of the mobile valve element;
d) determining, as the effect on the vibration state of the mass (1), the dither vibrations initiated, and
e) compensating for the dither vibrations by compensating control of actuators (10) which act on the mass (1).

11. Method for vibration isolation as claimed in Claim 10, **characterised in that** the pneumatic control loop (6) is operated with control fluctuations about a respective predetermined nominal value, and the control fluctuations are determined externally by the dither signal.

12. Method for vibration isolation as claimed in Claim 10 or 11, **characterised in that** step e) is carried out with the assistance of an vibration suppression control loop (11) and a dither compensation circuit (12), wherein dither signals are supplied to the dither compensation circuit (12).

13. Method for vibration isolation as claimed in Claim 12, **characterised in that** the dither compensation circuit (12) is supplied with signals according to step d).

14. Method for vibration isolation as claimed in any one of Claims 10 to 13, **characterised in that** the dither signal is a sinusoidal signal.

15. Method for vibration isolation as claimed in Claim 14, **characterised in that** the frequency of the dither signal is between 35 and 100 Hz.

## Revendications

1. Dispositif pour l'amortissement de vibrations d'une masse (1), comprenant
des coussinets d'air (2) pour le soutien de la masse (1) ;
un dispositif pour l'alimentation en pression des coussinets d'air (2), qui présente une source d'air comprimé (3) et une vanne de commande (4) pour un flux d'air comprimé à amener au coussinet d'air (2) ;
un circuit régulateur d'équipement pneumatique (6) pour la commande de la vanne de commande (4), qui présente un élément de vanne mobile ;
des moyens actionneurs (10) pour le soutien de la masse (1) destiné à la suppression des vibrations ;
un moyen détecteur (9) pour la constatation de l'état de vibration de la masse (1) ;
un circuit régulateur de suppression de vibration (11) pour la commande des moyens actionneurs (10) en fonction du moyen détecteur (9) ;
**caractérisé en ce que**
un générateur de signaux de superposition (Dither signal) (8) est prévu pour influencer l'état de déplacement de l'élément de vanne, des vibrations de signal de superposition de la masse (1) étant générées, et
**en ce qu'**un circuit de compensation de signal de superposition (12) est prévu pour commander les moyens actionneurs (10) dans le sens de la suppression de la vibration de signal de superposition de la masse (1).

2. Dispositif pour l'amortissement de vibrations selon la revendication 1,
**caractérisé en ce que** le circuit régulateur d'équipement pneumatique (6) peut être exploité avec des variations de réglage de respectivement une valeur de consigne prédéfinie, les variations de réglage étant prédéfinies de façon externe par le signal de superposition.

3. Dispositif pour l'amortissement de vibrations selon la revendication 1 ou 2, **caractérisé en ce que** le circuit régulateur d'équipement pneumatique (6) comporte un premier élément totalisateur (7), par lequel le générateur de signaux de superposition (8) est raccordé à la vanne de commande (4).

4. Dispositif pour l'amortissement de vibrations selon la revendication 1, 2 ou 3, **caractérisé en ce que** le circuit de régulateur d'équipement pneumatique (6) comporte un capteur de position (5).

5. Dispositif pour l'amortissement de vibrations selon l'une quelconque des revendications 1 à 4, **caractérisé en ce que** le circuit régulateur de suppression de vibrations (11) comporte un deuxième élément totalisateur (13), par lequel le circuit de compensation de signal de superposition (12) est raccordé aux moyens actionneurs (10).

6. Dispositif pour l'amortissement de vibrations selon l'une quelconque des revendications 1 à 5, **caractérisé en ce que** le générateur de signaux de superposition (8) est relié côté sortie à une entrée du circuit de compensation de signal de superposition (12).

7. Dispositif pour l'amortissement de vibrations selon l'une quelconque des revendications 1 à 6, **caractérise en ce que** le circuit de compensation de signal de superposition (12) est relié aux moyens dédecteurs (9) pour la constatation de l'état de vibration de la masse (1) et est intégré ainsi dans un circuit régulateur.

8. Dispositif pour l'amortissement de vibrations selon l'une quelconque des revendications 1 à 7, **caractérisé en ce que** le générateur de signaux de superposition (8) est un générateur de signaux sinusoïdaux.

9. Dispositif pour l'amortissement de vibrations selon la revendication 8, **caractérisé en ce que** la fréquence du signal de superposition se situe entre 35 et 100 Hz.

10. Dispositif pour l'amortissement de vibrations d'une masse (1) par le soutien au moyen d'une suspension pneumatique (2), présentant les étapes suivantes :
a) réglage de la pression d'air dans la suspension pneumatique (2) par l'arrivée d'air au moyen de vannes de commande (4), qui présente chacune un élément de vanne mobile et l'évacuation d'air de la suspension pneumatique (2) ;
b) génération d'un signal de réglage pour un circuit régulateur d'équipement pneumatique (6) pour influencer la position de l'élément de vanne mobile de la vanne de commande (4) ;
c) superposition du signal de réglage avec un signal de superposition, qui entraîne une vibration de signal de superposition de l'élément de vanne mobile ;
d) constatation de vibrations de signal de superposition déclenchées en conséquence de l'état de vibration de la masse (1), et
e) compensation des vibrations de signal de superposition par une commande compensatoire d'actionneurs (10), qui agissent sur la masse (1).

11. Procédé pour l'amortissement de vibrations selon la revendication 10, **caractérisé en ce que** le circuit régulateur d'équipement pneumatique (6) est exploité avec des variations de réglage de respectivement une valeur de consigne prédéfinie et les variations de réglage sont déterminées de façon externe par le signal de superposition.

12. Procédé pour l'amortissement de vibrations selon la revendication 10 ou 11, **caractérisé en ce que** l'étape e) est exécutée avec l'aide complémentaire d'un circuit régulateur de suppression de vibrations (11) et d'un circuit de compensation de signal de superposition (12), des signaux de superposition étant amenés au circuit de compensation de signal de superposition (12).

13. Procédé pour l'amortissement de vibrations selon la revendication 12, **caractérisé en ce que** des signaux selon l'étape d) sont amenés au circuit de compensation de signal de superposition (12).

14. Procédé pour l'amortissement de vibrations selon l'une quelconque des revendications 10 à 13, **caractérisé en ce que** le signal de superposition est un signal sinosoïdal.

15. Procédé pour l'amortissement de vibrations selon la revendication 14, **caractérisé en ce que** la fréquence du signal de superposition se situe entre 35 et 100 Hz.
